(19) Europäisches Patentamt
European Patent Office
Office européen des brevets

(11) **EP 3 598 157 A1**

(12) **DEMANDE DE BREVET EUROPEEN**

(43) Date de publication:
**22.01.2020 Bulletin 2020/04**

(51) Int Cl.:
***G01R 33/26*** *(2006.01)*

(21) Numéro de dépôt: **19186239.0**

(22) Date de dépôt: **15.07.2019**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **16.07.2018 FR 1856554**

(71) Demandeur: **COMMISSARIAT À L'ÉNERGIE
ATOMIQUE ET AUX
ÉNERGIES ALTERNATIVES
75015 Paris (FR)**

(72) Inventeurs:
• **PALACIOS LALOY, Agustin**
  **38054 GRENOBLE Cedex 09 (FR)**
• **BEATO, François**
  **38054 GRENOBLE Cedex 09 (FR)**
• **LIEB, Gaëtan**
  **38054 GRENOBLE Cedex 09 (FR)**

(74) Mandataire: **Brevalex
95, rue d'Amsterdam
75378 Paris Cedex 8 (FR)**

(54) **MAGNÉTOMÈTRE VECTORIEL EN ALIGNEMENT À DEUX FAISCEAUX DE SONDE POLARISÉS DIFFÉREMMENT**

(57) L'invention concerne un magnétomètre vectoriel (10) comprenant une cellule (1) destinée à être remplie d'un gaz atomique, une source optique et un dispositif de photo-détection. La source optique (2, 3, 9, 11) est configurée pour émettre en direction de la cellule :
- un premier et un deuxième faisceau optique, dits faisceaux de sonde (Fsy, Fsz), qui sont polarisés linéairement,
- un troisième faisceau optique, dit faisceau de pompe (Fp), polarisé linéairement.
Les directions de polarisation des faisceaux de sonde et la direction de polarisation du faisceau de pompe ne sont pas coplanaires.
Le dispositif de photo-détection (6) est configuré pour recevoir la lumière des faisceaux de sonde ayant traversés la cellule.
Les faisceaux de sonde peuvent avoir la même direction de propagation.
La direction de polarisation du faisceau de pompe peut former un angle de 45°±10° avec la direction de polarisation de chacun des faisceaux de sonde

FIG. 1

**Description**

**DOMAINE TECHNIQUE**

Le domaine de l'invention est celui des magnétomètres à pompage optique.

**ÉTAT DE LA TECHNIQUE ANTÉRIEURE**

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :

1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.
2) Ces états atomiques évoluent sous l'effet du champ magnétique, notamment sous l'effet Zeeman qui correspond à des décalages des niveaux d'énergie en fonction du champ magnétique auquel sont soumis les atomes.
3) Les propriétés optiques du milieu atomique subissent alors des modifications qui dépendent de l'état des atomes. On peut ainsi par une mesure optique, par exemple par une mesure d'absorption optique, remonter au décalage Zeeman subi, et en déduire une mesure du champ magnétique dans lequel est plongée la cellule.

Selon les différentes configurations possibles des magnétomètres à pompage optique existants, on distingue une mesure du module, aussi appelée norme, du champ magnétique pour les magnétomètres scalaires, ou une détermination des différentes composantes du champ magnétique pour les magnétomètres vectoriels, à l'emplacement de la cellule.

Le niveau de sensibilité, aussi appelé bas bruit, et de justesse atteignables avec de tels magnétomètres à pompage optique sont très remarquables et nettement plus favorables que ceux de la plupart des autres technologies de mesure magnétique (fluxgate, effet Hall, magnétorésistance, etc.). Seul le magnétomètre de type SQUID possède un bruit semblable, mais il requiert un refroidissement cryogénique de l'élément sensible, qui contient des éléments nécessitant d'être supraconducteurs pour son fonctionnement, ce qui restreint son champ d'application pratique.

Pour réaliser une mesure vectorielle du champ magnétique avec une bande passante large, il existe deux configurations bien connues : la première dite « à effet Hanle » et la deuxième qui reçoit le nom de « magnétomètre à résonance paramétrique ». Ces configurations sont décrites notamment dans l'article de J. Dupont-Roc, "Détermination par des méthodes optiques des trois composantes d'un champ magnétique très faible," Revue de Physique Appliquée, vol. 5, no. 6, pp. 853-864, 1970. Elles fonctionnent à des valeurs de champ magnétique extérieur très faibles, induisant un décalage Zeeman plus faible que le taux de relaxation des sous-niveaux Zeeman de l'atome, ce qui pour le cas de l'hélium fixe une limite autour de 100 nano Tesla, soit 500 fois moins intense que le champ magnétique terrestre.

Lorsqu'un faible champ magnétique statique transverse est appliqué à la cellule et balayé autour de zéro, les atomes sous soumis à un mouvement de précession et le nombre de photons absorbés, provenant du laser de pompage optique, subit des variations résonantes (effet Hanle). Des résonances analogues, appelées résonances paramétriques, sont observées lorsqu'un champ radiofréquence est appliqué. Dans ces conditions, le moment magnétique de chaque atome subit des oscillations résonantes aux fréquences multiples de celle du champ radiofréquence. La mesure de l'amplitude de ces oscillations permet de remonter au module de la composante du champ magnétique colinéaire au champ radiofréquence.

Le magnétomètre à effet Hanle a néanmoins pour inconvénients d'être sensible au bruit basse fréquence du laser de sonde et de reposer sur au moins deux accès optiques orthogonaux à la cellule de mesure, ce qui le rend encombrant et complexe à réaliser. Un tel magnétomètre, basé sur un pompage en polarisation circulaire, est par exemple décrit dans J. C. Allred, R. N. Lyman, T. W. Kornack, and M. V. Romalis, "High-Sensitivity Atomic Magnetometer Unaffected by Spin-Exchange Relaxation," Phys. Rev. Lett., vol. 89, no. 13, p. 130801, Sep. 2002.

Quant au magnétomètre à résonance paramétrique, s'il permet d'éviter des remontées de bruit typiquement présentes autour de la fréquence nulle en l'aide du ou des champs radiofréquence utilisés pour réaliser la modulation de fréquence des résonances magnétiques ainsi que de mesurer selon plusieurs axes sensibles en utilisant deux champs radiofréquence, il présente les inconvénients suivants :

- Son niveau de signal est dégradé du fait de présence du ou des champs RF, les amplitudes des signaux se retrouvant en effet multipliées par des combinaisons de fonctions de Bessel de première espèce inférieures à 1 ;
- Lorsque le magnétomètre est disposé avec d'autres magnétomètres du même type pour former un réseau (par exemple dans le but de réaliser de l'imagerie magnétique), les champs radiofréquence de chaque magnétomètre qui sont créés par des bobines autour de l'élément sensible peuvent affecter les magnétomètres voisins par le biais d'un couplage résiduel qui peut modifier notamment la direction de mesure de ceux-ci.

**EXPOSÉ DE L'INVENTION**

On cherche d'une manière générale à disposer d'un magnétomètre dont le rapport signal-à-bruit est le plus important possible. C'est notamment le cas dans des applications du magnétomètre où la mesure de champ magnétique sert à déduire la position de sources de champ (courants ou matériaux magnétiques) et où un rapport signal à bruit trop faible est susceptible d'induire de fortes incertitudes sur les grandeurs de ces sources ou leur localisation.

A cet effet, l'invention propose un magnétomètre vectoriel comprenant une cellule destinée à être remplie d'un gaz atomique, une source optique et un dispositif de photo-détection. La source optique est configurée pour émettre en direction de la cellule un premier et un deuxième faisceau optique, dits faisceaux de sonde (Fsy, Fsz), qui sont polarisés linéairement et un troisième faisceau optique, dit faisceau de pompe (Fp), polarisé linéairement au moins partiellement. Les directions de polarisation des faisceaux de sonde et la direction de polarisation du faisceau de pompe n'étant pas coplanaires. Le dispositif de photo-détection est configuré pour recevoir la lumière des faisceaux de sonde ayant traversés la cellule.

De telle sorte, l'invention propose un magnétomètre à effet Hanle peu sensible au bruit basse fréquence et qui présente deux voire trois axes sensibles sans pour autant être soumis aux inconvénients introduits par le ou les champs radiofréquence d'excitation de la résonance paramétrique.

Certains aspects préférés mais non limitatifs de ce magnétomètre sont les suivants :

- la source optique est configurée pour que les faisceaux de sonde se propagent selon une même direction de propagation et soient modulés différemment, le dispositif de photo-détection comportant un photodétecteur agencé pour recevoir la lumière ayant traversée la cellule dans la direction de propagation des faisceaux de sonde ;
- les faisceaux de sonde sont modulés à des fréquences différentes ;
- les faisceaux de sonde sont modulés à une même fréquence avec des phases en quadrature ;
- les faisceaux de sonde sont modulés en amplitude ou en polarisation ;
- la direction de polarisation du faisceau de pompe forme un angle de 45°±10° avec la direction de polarisation de chacun des faisceaux de sonde ;
- la direction de propagation des faisceaux de sonde étant selon l'axe Ox d'un repère orthonormé Oxyz, le premier faisceau optique présente une direction de polarisation selon l'axe Oy du repère orthonormé et le deuxième faisceau optique présente une direction de polarisation qui forme un angle de 60° avec la direction de la polarisation du premier faisceau optique ;
- la direction de propagation du faisceau de pompe forme un angle avec la direction de propagation des faisceaux de sonde qui est compris entre 35,3° et 70°, de préférence entre 35,3° et 45° ;
- la source optique est configurée pour émettre en direction de la cellule un quatrième faisceau optique qui présente une polarisation linéaire qui forme un angle de 45°°±10° avec la direction de propagation du faisceau de pompe et un angle de 90° avec la direction de polarisation du faisceau de pompe.

L'invention porte également sur un procédé de mesure d'un champ magnétique à l'aide d'un tel magnétomètre.

**BRÈVE DESCRIPTION DES DESSINS**

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma d'un magnétomètre conforme à l'invention ;
- les figures 2a et 2b illustrent la sensibilité d'un faisceau de sonde à différentes composantes du champ magnétique ambiant en fonction de la direction de polarisation du faisceau de sonde ;
- la figure 2c et la figure 3 représentent des directions optimales de polarisation de faisceaux de sonde dans deux repères différents ;
- la figure 4 est un schéma illustrant une propagation possible des faisceaux de pompe et de sonde dans un magnétomètre selon l'invention ;
- la figure 5 est un schéma d'une cellule de volume optimisé pouvant être utilisée dans un magnétomètre selon l'invention.

**EP 3 598 157 A1**

**EXPOSÉ DÉTAILLÉ DE MODES DE RÉALISATION PARTICULIERS**

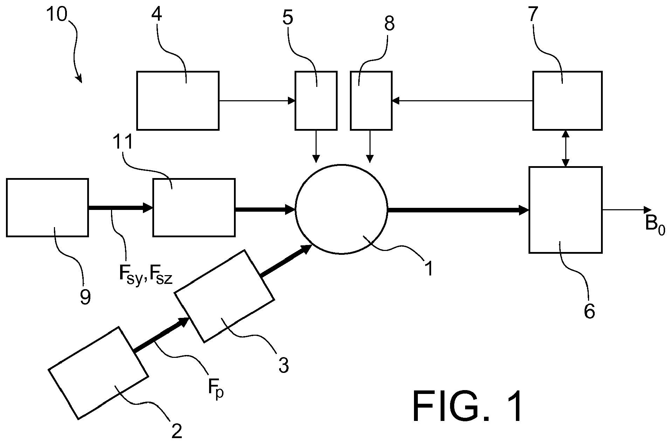

En référence à la figure 1, l'invention porte sur un magnétomètre vectoriel à pompage optique 10 qui comprend une cellule 1 remplie d'un gaz atomique apte à être polarisé en alignement, par exemple de l'hélium-4 ou un gaz alcalin, et qui est soumis à un champ magnétique ambiant $B_0$.

La cellule est éclairée par une source optique qui comprend notamment un élément de pompage 2 apte à émettre en direction de la cellule 1 un faisceau de lumière Fp, par exemple un faisceau laser, accordé à une longueur d'onde de pompage (ce faisceau est ainsi également désigné dans ce qui suit par le terme de faisceau de pompe). La longueur d'onde de pompage est calée sur une raie de transition atomique, par exemple sur la raie $D_0$ à 1083 nm dans le cas de l'hélium-4.

Dans le cas où l'élément sensible est l'hélium-4, le magnétomètre 10 comporte par ailleurs un système de décharge haute fréquence (HF), comprenant un générateur HF 4 et des bobines de surtension 5, pour amener les atomes du gaz atomique dans un état énergisé où ils sont aptes à subir la transition atomique lorsqu'ils sont éclairés par le faisceau de pompe Fp, typiquement dans l'état métastable $2^3S_1$.

Le faisceau de pompe Fp est polarisé au moyen d'un dispositif de polarisation 3 intercalé entre l'élément de pompage 2 et la cellule 1 ou directement intégré à l'élément de pompage 2. Dans le cadre de l'invention, le faisceau de pompe Fp est polarisé linéairement, partiellement ou totalement, ce qui induit des états atomiques dits « alignés » dans la cellule 1, l'axe d'alignement étant fixé par la direction du champ électrique de la lumière utilisée pour le pompage. Par partiellement polarisé, on entend que le faisceau de pompe Fp est en partie polarisé linéairement et en partie dépolarisé, ses paramètres de Stokes étant alors tels que S1+S2+S3 < S0 comme cela est présenté dans le chapitre 8 du livre « Optics » de Eugene Hecht, Addison Wesley 2002.

Le magnétomètre comprend par ailleurs un dispositif de photo-détection 6 qui reçoit de la lumière ayant traversée la cellule et délivre un signal porteur d'une information relative à l'état d'alignement des atomes du gaz atomique dans la cellule à une électronique de traitement qui exploite ce signal pour fournir une mesure du champ ambiant $B_0$.

Le magnétomètre peut également comprendre un système d'asservissement en boucle fermé du magnétomètre pour venir constamment soumettre l'élément sensible à un champ magnétique total nul. Le système d'asservissement comprend un régulateur 7 couplé à l'électronique de traitement et qui injecte un courant dans des bobines de Helmholtz 8 d'axes orthogonaux qui entourent la cellule 1 afin de générer un champ magnétique de compensation Bc tel que la somme Bc+$B_0$ est maintenue à zéro en permanence.

Alternativement, le magnétomètre peut être opéré en boucle ouverte, sans compensation du champ ambiant.

Le magnétomètre peut par ailleurs être placé à l'intérieur d'un blindage magnétique qui assure que le champ terrestre, ainsi que d'autres perturbations magnétiques, sont absents en son intérieur. Un blindage disposant de plusieurs couches de matériaux ferromagnétiques tels que le mu-métal permet en effet d'assurer des niveaux de champs résiduels à l'intérieur du blindages inférieurs à la centaine de nano Tesla.

Dans le cadre de l'invention, le faisceau de pompe Fp n'est pas utilisé pour la détection de l'état d'alignement des atomes du gaz atomique dans la cellule. Pour assurer cette détection, la source optique comprend en outre un élément de sondage 9 apte à émettre en direction de la cellule 1 deux, voire trois, faisceaux de lumière Fsy, Fsz, par exemple des faisceaux laser, qui sont également accordés à la raie de transition atomique visée et sont appelés faisceaux de sonde.

Il est possible d'utiliser un laser indépendant pour chacun des faisceaux de pompe et de sonde. Dans une variante de réalisation, il est possible d'utiliser un seul laser associé à un diviseur optique en trois voies (une de pompe et deux de sonde) ou en quatre voies lorsqu'un troisième faisceau de sonde est utilisé.

Comme représenté en figure 1, ces faisceaux Fsy, Fsz, dits faisceaux de sonde dans ce qui suit, sont polarisés linéairement au moyen d'un dispositif de polarisation 11 intercalé entre l'élément de sondage 9 et la cellule ou directement intégré à l'élément de sondage 9.

Les directions de polarisation des deux faisceaux de sonde et la direction de polarisation du faisceau de pompe ne sont pas coplanaires de manière à ce que le magnétomètre puisse déduire différentes composantes du champ magnétique. Le magnétomètre présente ainsi un premier axe sensible normal au plan défini par la direction de polarisation du premier faisceau de sonde et la direction de polarisation du faisceau de pompe, et un deuxième axe sensible normal au plan défini par la direction de polarisation du second faisceau de sonde et la direction de polarisation du faisceau de pompe.

L'orientation de la polarisation linéaire de chacun des faisceaux de sonde peut être optimisée comme cela sera décrit par la suite afin de rendre le magnétomètre sensible à des composantes du magnétique $B_0$ indépendantes entre elles (la projection de l'une sur l'autre est nulle) tout en maximisant cette sensibilité.

Si les faisceaux de sonde Fsy, Fsz ne se propagent selon une même direction de propagation, le dispositif de photo-détection peut comporter deux photodétecteurs, chacun agencé pour recevoir la lumière ayant traversée la cellule dans la direction de propagation de l'un des faisceaux de sonde.

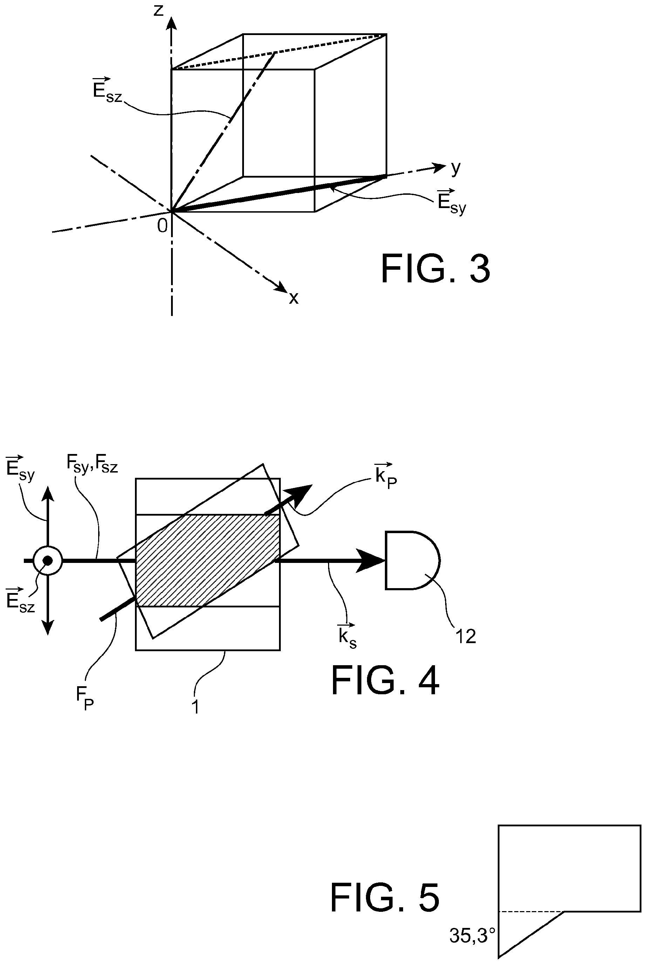

Dans un mode de réalisation représenté sur la figure 4, les faisceaux de sonde Fsy, Fsz se propagent selon

**4**

une même direction de propagation $\vec{k_s}$ de manière à réduire le nombre d'accès optiques à la cellule 1. Le dispositif de photo-détection peut alors ne comprendre qu'un seul photodétecteur 12 agencé pour recevoir la lumière ayant traversée la cellule dans la direction de propagation $\vec{k_s}$ des faisceaux de sonde Fsy, Fsz. La propagation d'un faisceau étant orthogonale à sa polarisation, la direction de polarisation $\overrightarrow{E_{sy}}$, $\overrightarrow{E_{sz}}$ de chacun des faisceaux de sonde est orthogonale à la direction de propagation commune $\vec{k_s}$ comme représenté en figure 4.

Dans un tel cas de figure, les faisceaux de sonde sont modulés différemment pour permettre à l'électronique de traitement de séparer l'information portée par chacun de ces faisceaux après traversée de la cellule 1. Les faisceaux de sonde peuvent être modulés en amplitude, en polarisation, voire en longueur d'onde dans un mode dégradé d'implémentation d'une modulation d'amplitude. La fréquence de modulation peut être suffisamment élevée, par exemple de l'ordre de 30 kHz, pour s'affranchir des problématiques de bruit basse fréquence du ou des lasers fournissant les faisceaux de sonde, sans pour autant perdre en amplitude de signal à la différence d'un magnétomètre à résonance paramétrique. Le magnétomètre selon l'invention réalise donc un magnétomètre à effet Hanle dont la sensibilité au bruit est réduite et qui présente (au moins) deux axes sensibles, ces bénéfices étant atteints sans introduire les problèmes liés à l'utilisation des champs RF dans les magnétomètres à résonance paramétrique.

Les faisceaux de sonde peuvent être modulés à des fréquences différentes, ou modulés à une même fréquence mais avec des phases en quadrature (c'est-à-dire à 90° de phase l'un par rapport à l'autre).

Les faisceaux optiques émis par la source optique peuvent être produits par des lasers, par exemple des diodes semi-conductrices. Les deux faisceaux de sonde peuvent à titre d'exemple être modulés en amplitude à des fréquences de modulation de 17 kHz et 26 kHz respectivement. Cette modulation peut être par exemple réalisée à l'aide d'un modulateur photo-acoustique ou d'un modulateur à cristaux liquides dont la bande passante limitée est suffisante pour assurer une modulation jusqu'à la dizaine de kHz. Chaque photodétecteur peut être une photodiode, par exemple une photodiode d'InGaAs particulièrement sensible dans le proche infrarouge, domaine dans lequel se trouve la lumière des faisceaux de sonde. La photodiode est connectée à un amplificateur de transimpédance à la sortie duquel on dispose d'un signal qui présente deux composantes fréquentielles, l'une à 17 kHz et l'autre l'autre à 26 kHz par exemple, chacune associée à l'un des faisceaux de sonde.

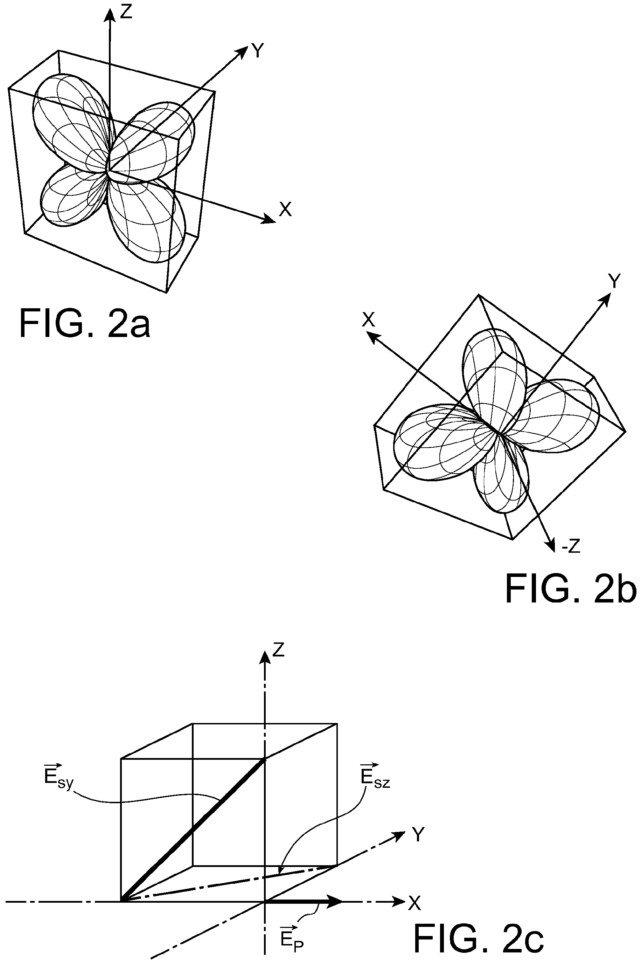

La projection du champ magnétique ambiant $B_0$ sur trois axes de coordonnées rectangulaires définit trois composantes du champ. En référence aux figures 2a-2c, on choisit un trièdre de référence XYZ dont l'axe X est aligné sur la direction de polarisation $\overrightarrow{E_p}$ du faisceau de pompe. Le champ magnétique ambiant $B_0$ se décompose ainsi en trois composantes $B_X$, $B_Y$ et $B_Z$, chacune selon l'un des axes de mesure du magnétomètre X, Y et Z.

Dans un mode de réalisation de l'invention, le magnétomètre exploite pour faisceaux de sonde des faisceaux optimaux, sonde Y et sonde Z, détaillés ci-après, ou à tout le moins des faisceaux proches d'être optimaux, sonde Y' et sonde Z', dont les directions de polarisation présentent respectivement un décalage angulaire de +/- 10° par rapport à la direction de polarisation du faisceau optimal correspondant sonde Y et sonde Z.

On a représenté sur la figure 2a la sensibilité d'un faisceau de sonde au champ magnétique $B_Y$ selon l'axe Y en fonction de la direction de polarisation du faisceau de sonde. On en déduit que la polarisation qui permet de réaliser une mesure du champ $B_Y$ avec un niveau de signal optimal est celle formant un angle de 45° avec l'axe X et 90° avec l'axe Y. Un faisceau de sonde ainsi polarisé est désigné par le terme de sonde Y par la suite.

La figure 2b illustre quant à elle la sensibilité d'un faisceau de sonde au champ magnétique Bz selon l'axe Z en fonction de la direction de polarisation du faisceau de sonde. On en déduit que la polarisation qui permet de réaliser une mesure du champ $B_Z$ avec un niveau de signal optimal est celle formant un angle de 45° avec l'axe X et 90° avec l'axe Z. Un faisceau de sonde ainsi polarisé est désigné par le terme de sonde Z par la suite.

On a représenté sur la figure 2c des exemples de telles polarisations optimales, selon la direction $\overrightarrow{E_{sy}}$ pour la sonde Y et selon la direction $\overrightarrow{E_{sz}}$ pour la sonde Z, dans le trièdre XYZ.

Dans ce qui suit les différentes directions sont associées aux vecteurs unitaires correspondant dans un repère othonormé Oxyz représenté en figure 3, dont l'axe Ox de vecteur unitaire $\vec{x}$ est aligné sur la direction de propagation d'un premier faisceau optique de sonde qui est polarisé linéairement selon l'axe Oy de ce même référentiel. En l'occurrence, il s'agit de la sonde Y dont la direction de polarisation $\overrightarrow{E_{sy}} = \vec{y}$ est selon l'axe Oy de vecteur unitaire $\vec{y}$ et dont la direction de propagation $\vec{k_{sy}} = \vec{x}$ est selon l'axe Ox.

Le deuxième faisceau optique de sonde, en l'occurrence la sonde Z, présente une même direction de propagation $\vec{k_{sz}} = \vec{x}$ et une direction de polarisation $\overrightarrow{E_{sz}}$ dans le plan Oyz qui forme un angle de 60° avec la direction de

$$\overrightarrow{E_{sy}} = \frac{1}{2}\vec{y} + \frac{\sqrt{3}}{2}\vec{z}.$$

polarisation $\overrightarrow{E_{sy}}$ de la sonde Y, soit

Le faisceau de pompe Fp se propage dans une direction $\vec{k_p}$ faisant un angle non nul avec la direction de propagation $\vec{k_{sy}} = \vec{k_{sy}} = \vec{x}$ des faisceaux de sonde. Dans un mode de réalisation avantageux représenté sur la figure 4, le faisceau de pompe Fp entre dans la cellule 1 par la même face optique par laquelle entrent les faisceaux de sonde Fsy, Fsz ce qui simplifie la mise en oeuvre. La direction optimale de la propagation du faisceau de pompe pour obtenir cet effet (en ce sens que les trois faisceaux optiques sont au plus proche les uns des autres sur la face optique d'entrée, maximisent la zone de mesure utile et réduisent l'encombrement) est celle où elle forme un angle de $\mathrm{acos}(\frac{2}{\sqrt{3}})$, soit environ 35,3°, avec la direction de propagation des faisceaux de sonde, cet angle étant mesuré dans le plan orthogonal à l'axe X de polarisation du faisceau de pompe. On adopte alors pour cet angle une valeur comprise entre 35,3° et 90°, de préférence une valeur comprise entre 35,3° et 70°, et encore plus de préférence une valeur comprise entre 35,3° et 45°.

Sur cette figure 4, la zone hachurée représente la zone de mesure utile dans la cellule, correspondant à l'intersection des rectangles symbolisant respectivement la largeur des faisceaux de sonde et la largeur du faisceau de pompe. On a représenté sur la figure 5 une cellule de volume optimisé pour laquelle on a supprimé toutes les parties non utiles à la mesure. Cette cellule présente une « oreille » offrant un accès au faisceau de pompe selon l'angle optimal de 35,3°.

Comme on l'a vu précédemment, la direction de polarisation du faisceau de pompe $\overrightarrow{E_p}$ est telle qu'elle forme un angle de 45° avec la direction de polarisation $\overrightarrow{E_{sy}}$ de la sonde Y et un angle de 45° avec la direction de polarisation $\overrightarrow{E_{sz}}$ de la sonde Z.

On en déduit les formules analytiques suivantes :s

$$\overrightarrow{k_p} = -\sqrt{\frac{2}{3}}\vec{x} + \frac{1}{2}\vec{y} + \frac{1}{2\sqrt{3}}\vec{z} \quad \text{et} \quad \overrightarrow{E_p} = \frac{1}{\sqrt{3}}\vec{x} + \frac{1}{\sqrt{2}}\vec{y} + \frac{1}{\sqrt{6}}\vec{z}$$

En exploitant les faisceaux présentant les directions optimales discutées ci-dessus, et reprenant l'exemple de faisceaux de sonde modulés à des fréquences différentes et d'un magnétomètre non opéré champ nul, on retrouve en sortie de l'amplificateur auquel est connectée la photodiode 12 deux composantes fréquentielles, l'une, par exemple à 17 kHz, qui dans une gamme de champ de quelques dizaines de nT autour du champ nul est directement proportionnelle au champ $B_Y$ selon l'axe Y et l'autre, par exemple à 26 kHz, qui dans une gamme de champ de quelques dizaines de nT autour du champ nul est directement proportionnelle au champ Bz selon l'axe Z.

Ces axes Y et Z de sensibilité du magnétomètre sont définis comme suit dans le repère Oxyz. L'axe Y est orthogonal à la direction de polarisation du faisceau de pompe ainsi qu'à la direction de l'axe Oy (direction de polarisation de la sonde Y). L'axe Z est quant à lui orthogonal à la direction de polarisation du faisceau de pompe, ainsi qu'à la direction de polarisation de la sonde Z. On en déduit $\vec{Y} = -\frac{1}{\sqrt{3}}\vec{x} + \sqrt{\frac{2}{3}}\vec{z}$ et $\vec{Z} = -\frac{1}{\sqrt{3}}\vec{x} + \frac{1}{\sqrt{2}}\vec{y} - \frac{1}{\sqrt{6}}\vec{z}$.

On a vu dans ce qui précède que le magnétomètre selon l'invention présente deux axes sensibles. Dans une variante de réalisation, il est possible de réaliser une mesure du champ magnétique ambiante en adoptant un faisceau de pompe partiellement polarisé. La source optique peut alors être configurée pour émettre en direction de la cellule un quatrième faisceau optique, à savoir un troisième faisceau de sonde, qui de manière optimale présente une polarisation linéaire qui forme un angle de 45° avec la direction de propagation du faisceau de pompe et un angle de 90° avec la direction de polarisation du faisceau de pompe. Les quatre faisceaux optiques peuvent être injectés dans la cellule à partir d'un seul accès optique. Les deux premiers faisceaux de sonde, sonde Y et sonde Z, présentent la même direction de propagation. La propagation du faisceau de pompe peut en particulier former un angle de 35.3° avec la direction de propagation des deux premiers faisceaux de sonde, cet angle étant mesuré dans le plan qui inclut les deux directions de propagation qui est le plan XZ. La propagation du troisième faisceau de sonde peut également former un angle de 35.3° avec la direction de propagation des deux premiers faisceaux de sonde, cet angle étant mesuré dans le plan qui inclut les deux directions de propagation qui est, au choix, le plan YZ ou le plan XY. Le magnétomètre comporte un photodétecteur sur lequel est incident le troisième faisceau de sonde après traversé de la cellule. Ce photodétecteur fournit un signal représentatif de la composante du champ magnétique ambiant selon l'axe X. A l'image des faisceaux de sonde Y et sonde Z, le troisième faisceau de sonde peut fait l'objet d'une modulation.

L'invention porte également sur un procédé de mesure d'un champ magnétique à l'aide du magnétomètre vectoriel tel que précédemment décrit. Ce procédé comprend notamment l'émission en direction de la cellule :

- d'un premier et un deuxième faisceau optique, dits faisceaux de sonde, qui sont polarisés linéairement avec des directions de polarisation différentes,
- d'un troisième faisceau optique, dit faisceau de pompe, polarisé linéairement totalement ou partiellement,
- ladite émission étant réalisée de telle manière que les directions de polarisation des faisceaux de sonde et la direction de polarisation du faisceau de pompe ne sont pas coplanaires,

et la détection de la lumière des faisceaux de sonde ayant traversés la cellule.

## Revendications

1. Magnétomètre vectoriel (10) comprenant une cellule (1) destinée à être remplie d'un gaz atomique, une source optique et un dispositif de photo-détection, **caractérisé en ce que** la source optique (2, 3, 9, 11) est configurée pour émettre en direction de la cellule :

   - un premier et un deuxième faisceau optique, dits faisceaux de sonde (Fsy, Fsz), qui sont polarisés linéairement,
   - un troisième faisceau optique, dit faisceau de pompe (Fp), polarisé linéairement au moins partiellement,
   - les directions de polarisation des faisceaux de sonde et la direction de polarisation du faisceau de pompe n'étant pas coplanaires,

   et **en ce que** le dispositif de photo-détection (6) est configuré pour recevoir la lumière (L) des faisceaux de sonde ayant traversés la cellule.

2. Magnétomètre vectoriel (10) selon la revendication 1, dans lequel la source optique est configurée pour que les faisceaux de sonde se propagent selon une même direction de propagation et soient modulés différemment, et dans lequel le dispositif de photo-détection comporte un photodétecteur agencé pour recevoir la lumière ayant traversée la cellule dans la direction de propagation des faisceaux de sonde.

3. Magnétomètre vectoriel (10) selon la revendication 2, dans lequel les faisceaux de sonde sont modulés à des fréquences différentes.

4. Magnétomètre vectoriel (10) selon la revendication 2, dans lequel les faisceaux de sonde sont modulés à une même fréquence avec des phases en quadrature.

5. Magnétomètre vectoriel selon l'une des revendications 2 à 4, dans lequel les faisceaux de sonde sont modulés en amplitude ou en polarisation.

6. Magnétomètre vectoriel selon l'une des revendications 2 à 5, dans lequel la direction de polarisation du faisceau de pompe forme un angle de $45° \pm 10°$ avec la direction de polarisation de chacun des faisceaux de sonde.

7. Magnétomètre selon la revendication 6, dans lequel la direction de propagation des faisceaux de sonde étant selon l'axe Ox d'un repère orthonormé Oxyz, le premier faisceau optique présente une direction de polarisation selon l'axe Oy du repère orthonormé et le deuxième faisceau optique présente une direction de polarisation qui forme un angle de 60° avec la direction de la polarisation du premier faisceau optique.

8. Magnétomètre vectoriel selon l'une des revendications 2 à 5, dans lequel la direction de propagation du faisceau de pompe forme un angle avec la direction de propagation des faisceaux de sonde qui est compris entre 35,3° et 70°, de préférence entre 35,3° et 45°.

9. Magnétomètre vectoriel selon l'une des revendications 1 à 8, dans lequel la source optique est configurée pour émettre en direction de la cellule un quatrième faisceau optique qui présente une polarisation linéaire qui forme un angle de $45°° \pm 10°$ avec la direction de propagation du faisceau de pompe et un angle de 90° avec la direction de polarisation du faisceau de pompe.

10. Magnétomètre vectoriel selon l'une des revendications 1 à 9, comprenant en outre un système d'asservissement en boucle fermé du magnétomètre pour le faire fonctionner en champ nul.

11. Procédé de mesure d'un champ magnétique à l'aide d'un magnétomètre vectoriel (10) comprenant une cellule (1) remplie d'un gaz atomique soumis à un champ magnétique ambiant, une source optique et un dispositif de photo-détection, le procédé comprenant :

   - l'émission, par la source optique, en direction de la cellule :

◦ d'un premier et un deuxième faisceau optique, dits faisceaux de sonde, qui sont polarisés linéairement,
◦ d'un troisième faisceau optique, dit faisceau de pompe, polarisé linéairement totalement ou partiellement,
◦ ladite émission étant réalisée de telle manière que les directions de polarisation des faisceaux de sonde et la direction de polarisation du faisceau de pompe ne sont pas coplanaires ; et

- la détection, à l'aide du dispositif de photo-détection, de la lumière des faisceaux de sonde ayant traversés la cellule.

FIG. 1

FIG. 2a

FIG. 2b

FIG. 2c

FIG. 3

FIG. 4

FIG. 5

Europäisches Patentamt

European Patent Office

Office européen des brevets

# RAPPORT DE RECHERCHE EUROPEENNE

Numéro de la demande

EP 19 18 6239

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | PATTON B ET AL: "All-Optical Vector Atomic Magnetometer", ARXIV.ORG, CORNELL UNIVERSITY LIBRARY, 201 OLIN LIBRARY CORNELL UNIVERSITY ITHACA, NY 14853, 28 mars 2014 (2014-03-28), XP080008594, DOI: 10.1103/PHYSREVLETT.113.013001 * le document en entier * | 1-11 | INV. G01R33/26 |
| A | SUN WEI-MIN ET AL: "All-Optical Vector Cesium Magnetometer", CHIN. PHYS. LETT, vol. 34, no. 5, 2017, pages 058501-1, XP055590688, * le document en entier * | 1-11 | |
| A | FR 2 663 432 A1 (COMMISSARIAT ENERGIE ATOMIQUE [FR]) 20 décembre 1991 (1991-12-20) * revendications 1,4,13; figure 2a * | 1-11 | |
| A | NATSUHIKO MIZUTANI ET AL: "Magnetic Field Vector Detection in Frequency Domain with an Optically Pumped Atomic Magnetometer", IEEE TRANSACTIONS ON MAGNETICS, IEEE SERVICE CENTER, NEW YORK, NY, US, vol. 48, no. 11, novembre 2012 (2012-11), pages 4096-4099, XP011468941, ISSN: 0018-9464, DOI: 10.1109/TMAG.2012.2200657 * figure 1 * | 1-11 | DOMAINES TECHNIQUES RECHERCHES (IPC) G01R |

-/--

Le présent rapport a été établi pour toutes les revendications

| Lieu de la recherche | Date d'achèvement de la recherche | Examinateur |
|---|---|---|
| Munich | 5 novembre 2019 | Skalla, Jörg |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 19 18 6239

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | SELTZER S ET AL: "Unshielded three-axis vector operation of a spin-exchange-relaxation-free atomic magnetometer", APPLIED PHYSICS LETTERS, A I P PUBLISHING LLC, US, vol. 85, no. 20, 16 novembre 2004 (2004-11-16), pages 4804-4806, XP012063471, ISSN: 0003-6951, DOI: 10.1063/1.1814434 * le document en entier * ----- | 1-11 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 5 novembre 2019 | Skalla, Jörg |

CATEGORIE DES DOCUMENTS CITES

X : particulièrement pertinent à lui seul
Y : particulièrement pertinent en combinaison avec un
  autre document de la même catégorie
A : arrière-plan technologique
O : divulgation non-écrite
P : document intercalaire

T : théorie ou principe à la base de l'invention
E : document de brevet antérieur, mais publié à la
  date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 19 18 6239

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-11-2019

| Document brevet cité au rapport de recherche | Date de publication | Membre(s) de la famille de brevet(s) | Date de publication |
|---|---|---|---|
| FR 2663432 A1 | 20-12-1991 | CA 2044539 A1 | 15-12-1991 |
| | | DE 69100783 D1 | 27-01-1994 |
| | | DE 69100783 T2 | 09-06-1994 |
| | | EP 0462000 A1 | 18-12-1991 |
| | | FR 2663432 A1 | 20-12-1991 |
| | | US 5254947 A | 19-10-1993 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J. DUPONT-ROC.** Détermination par des méthodes optiques des trois composantes d'un champ magnétique très faible. *Revue de Physique Appliquée,* 1970, vol. 5 (6), 853-864

- **J. C. ALLRED ; R. N. LYMAN ; T. W. KORNACK ; M. V. ROMALIS.** High-Sensitivity Atomic Magnetometer Unaffected by Spin-Exchange Relaxation. *Phys. Rev. Lett.,* Septembre 2002, vol. 89 (13), 130801
- **EUGENE HECHT.** Optics. Addison Wesley, 2002